# EUROPEAN PATENT SPECIFICATION

(11) **EP 0 763 851 B1**
(45) Date of publication and mention of the grant of the patent: **13.02.2002**
(21) Application number: 96113459.0
(22) Date of filing: 22.08.1996
(51) Int. Cl.: H01L 21/336, H01L 21/8234, H01L 29/78

(54) **Method of forming an asymmetric, graded-channel semiconductor device using a disposable spacer**
Verfahren zur Herstellung eines Halbleiterbauelements mit gradiertem asymmetrischem Kanal mittels abnehmbaren Abstandstück
Méthode de fabrication d'un dispositif semi-conducteur à canal gradué et asymétrique à l'aide d'un écarteur enlevable

(30) Priority: 30.08.1995 US 521504; 01.12.1995 US 566320
(43) Date of publication of application: 19.03.1997
(73) Proprietor: MOTOROLA, INC., Schaumburg, IL 60196 (US)
(72) Inventor: Dow, Diann M., Chandler, Arizona 85224 (US); Davies, Robert B., Tempe, Arizona 85281 (US); Wild, Andreas A., Scottsdale, Arizona 85258 (US); Ilderem, Vida, Phoenix, Arizona 85048 (US)
(74) Representative: Gibson, Sarah Jane

(56) References cited:
- US-A- 5 427 964
- PATENT ABSTRACTS OF JAPAN vol. 014, no. 178 (E-0915), 10 April 1990 -& JP 02 030185 A (HITACHI LTD;OTHERS: 01), 31 January 1990,
- BUTI T N ET AL: "A NEW ASYMMETRICAL HALO SOURCE GOLD DRAIN (HS-GOLD) DEEP SUB-HALF-MICROMETER N-MOSFET DESIGN FOR RELIABILITY AND PERFORMANCE" IEEE TRANSACTIONS ON ELECTRON DEVICES, vol. 38, no. 8, 1 August 1991, pages 1757-1764, XP000217059

## Description

### Background of the Invention

The present invention relates, in general, to semiconductor devices and, more particularly, to field effect transistors.

A unilateral, graded-channel insulated gate field effect transistor (IGFET) has a channel region with a laterally graded dopant profile. Typically, a graded channel region is formed under the gate electrode and extends from the doped source region a significant distance under the gate electrode into the channel region. The device is described as "unilateral" because the graded channel region is formed on only the source side of the device. The graded channel region uses a dopant of the same conductivity type as the substrate or well in which the IGFET is formed, and the carrier concentration profile varies gradually from a maximum concentration at the interface with the source region to a minimum concentration corresponding to the background carrier concentration (in other words, the carrier concentration of the substrate or well). A graded channel provides several advantages including higher carrier mobility, lower body effect, higher punch-through resistance, and lower sensitivity to gate length.

US5427964 discloses an insulated gate field effect transistor and method of fabricating an insulated gate field effect transistor. JP63179048 (Patent Abstracts of Japan, abstract publication no. 02030185 published 31 January 1990) discloses a semiconductor device and manufacture thereof with the purpose to reduce a junction leakage current on the side of a source in an asymmetrical MOS transistor.

The device sensitivities of a unilateral, graded-channel IGFET are significantly different than that of a uniform channel IGFET and thus several problems associated with their manufacture have not been addressed in the past. First, when forming a graded channel IGFET, it is sometimes desirable to form the graded channel region using an angled ion implantation, which is difficult because it requires a masking technique having a low aspect ratio. Also, it is often desirable to dope the gate electrode in the same step as the source/drain regions, which is impractical when using a photoresist mask for a sub-micron device due to the desire to have a lightly-doped drain (LDD) extension on only the drain side of the device.

Further, when doping using photoresist masks with sub-micron devices, it is difficult to consistently avoid contamination of the channel region on the drain side of the gate electrode by dopant intended for the graded channel region on the source side due to photoresist mask misalignments. This problem is particularly acute when several devices are coupled in series and minimally-spaced, with a common source/drain region acting as the source region of one device and the drain region of the second device. When so minimally-spaced the common source/drain region has a size corresponding to a design rule minimum dimension, and the misalignment of the photoresist mask used for doping the graded channel region on the source side of the first device will permit some graded-channel dopant to diffuse into the channel region on the drain side of the second device.

Another problem encountered when using minimally-spaced devices as discussed above is that a photoresist mask misalignment can result in an insufficient surface area of the substrate being exposed on the source side of a device such that the graded channel region cannot be fully formed. This source-limited diffusion occurs because there is an inadequate initial supply of dopant due to the small substrate area exposed on the source side of the device. Accordingly, there is a need for an improved method of forming graded-channel field effect transistors that reduces the adverse effects of the several problems described above.

### Brief Description of the Drawings

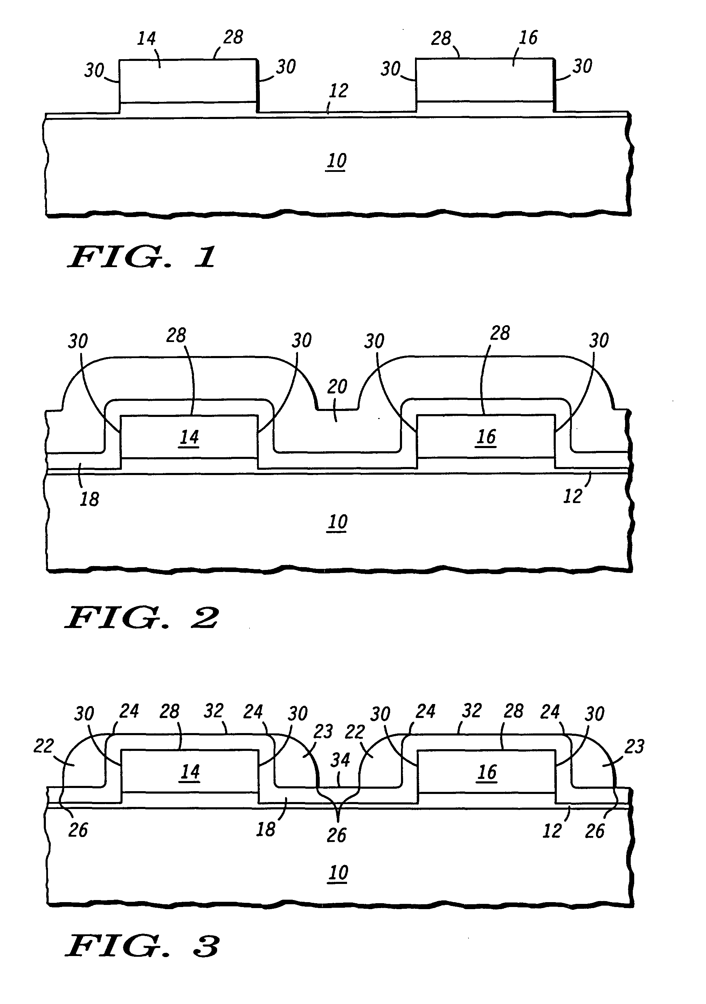

FIGs. 1-9 are cross-sectional views illustrating various stages in the formation of a field effect transistor according to the method of embodiments of the present invention.

### Detailed Description of the Drawings

The present invention according to claim 1 provides an improved method for forming a unilateral, graded-channel field effect transistor. According to this method, a gate electrode is provided overlying a semiconductor substrate. A spacer is formed adjacent to the gate electrode on the drain side of the transistor, and a graded-channel doped region is formed in the semiconductor substrate on the source side of the transistor. The graded-channel doped region is aligned to the gate electrode, and the spacer substantially reduces the extent to which any graded-channel dopant diffuses under the gate electrode on the drain side. After the graded-channel dopant is introduced into the substrate, the spacer can either be removed or used for forming a lightly-doped drain extension region.

FIGs. 1-9 are cross-sectional views illustrating stages in the formation of a unilateral, graded-channel IGFET according to a preferred embodiment of the present invention. Specifically, by way of example only, an N-channel, enhancement-mode device is described herein, but those skilled in the art will readily recognize that substitutions of dopant types, materials and processes can be made to the following described method while remaining within the scope of embodiments of the present invention. For example, P-channel devices can also be formed using embodiments of the present invention with appropriate changes in dopant conductivity types.

In FIG. 1 a semiconductor substrate 10 is provided, which is preferably silicon and lightly-doped to have a P-type conductivity. An insulating layer 12 of, for example, grown silicon oxide of about 100 angstroms thickness, is formed on substrate 10 to provide a gate insulating layer for the final devices. Gate electrodes 14 and 16, which are preferably polysilicon, are formed on insulating layer 12. As is known, etching of polysilicon to form electrodes 14 and 16 typically thins insulating layer 12 in the regions between electrodes 14 and 16. Gate electrodes 14 and 16 have a top surface 28 and sidewalls 30. If desired, gate electrodes 14 and 16 can be minimally-spaced in order to share a common source/drain region to be formed later. Typically, no contact will be formed between gate electrodes 14 and 16 when they are minimally-spaced.

In FIG. 2, a blanket, conformal dielectric layer 18 is formed over insulating layer 12 and electrodes 14 and 16. Dielectric layer 18 is, for example, a deposited silicon oxide layer of about 100-200 angstroms thickness. Next, a blanket spacer layer 20, which is preferably polysilicon having a thickness of about 1,000-2,500 angstroms, is formed over dielectric layer 18. Spacer layer 20 will be etched next to form spacers.

Referring to FIG. 3, spacer layer 20 is anisotropically etched to form spacers 22 and 23 adjacent to sidewalls 30. Spacers 22 and 23 have bottom corners 26 distal from electrodes 14 and 16, and spacers 22 and 23 further have top corners 24 proximate to electrodes 14 and 16 and a top surface 32 of dielectric layer 18. The base width of spacers 22 and 23 is preferably about 0.1-0.2 microns. During this etch, dielectric layer 18 is used as an etch stop. For the preferred case where dielectric layer 18 is silicon oxide and spacer layer 20 is polysilicon, the etch selectivity ratio is about 100:1, which assists in the formation of spacers 22 and 23 as just described. Following this etch, top surface 32 and a bottom surface 34 of dielectric layer 18 are substantially free of spacer layer 20.

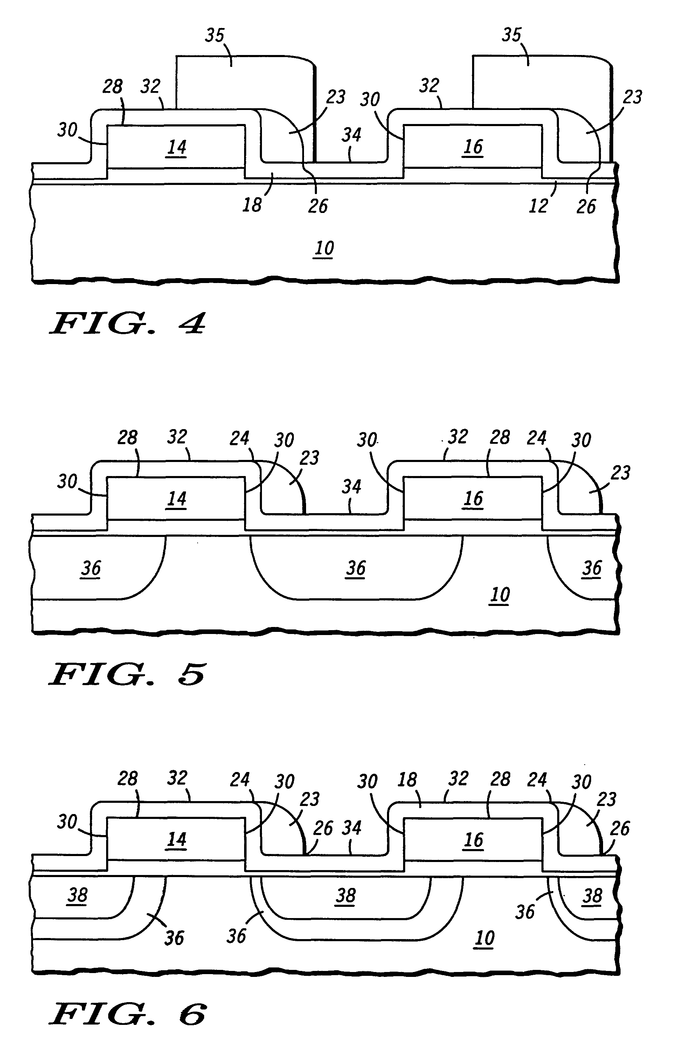

FIG. 4 illustrates a processing stage in which spacers 22 (see FIG. 3) have been removed in preparation for the formation of a unilaterally-doped device. Spacers 22 correspond to the source side of each device, and spacers 23 correspond to the drain side as will become more clear below. A mask 35, for example, of photoresist is formed and patterned to protect spacers 23. Then, spacers 22 are removed by, for example, conventional etching again using dielectric layer 18 as an etch stop.

FIG. 5 illustrates the formation of graded-channel doped regions 36 in substrate 10. Doped regions 36 have the same conductivity type as substrate 10, which is P-type in this example. Doped regions 36 are preferably formed using an ion implantation of boron at a dose of 4.5x10¹³ atoms/cm² and an energy of 20 keV. This ion implantation can be performed normal to the surface of substrate 10 or at a angle thereto. Spacers 22 (see FIG. 3) were removed so that doped regions 36 are substantially aligned to sidewalls 30 on the source side of each device. Spacers 23 are retained during doping so that diffusion of the graded-channel dopant is substantially reduced into the drain side of the channel region of each device. If too much graded-channel dopant is introduced into the drain side of the channel, the threshold voltage will increase, the body effect will increase, and mobility will be reduced resulting in a lower drive current. Further, the graded-channel dopant can adversely counter-dope the drain extension regions to be formed later in the process resulting in reduced effectiveness in field-shaping on the drain side of the channel.

Following implantation, doped regions 36 are thermally annealed to extend doped regions 36 substantially into the channel region on the source side of each device. This thermal anneal also activates doped region 36. By way of example, a 10-60 minute anneal at a temperature of about 875-1,000°C in a non-oxidizing ambient can be used.

An advantage of the present invention is that spacers 23 have a low profile such that they do not fully or partially block a steep angled implantation of graded-channel dopant. In contrast, a masking technique using a photoresist has a profile significantly higher such that steep angled implantation is not practical because of photoresist shadowing. It should be appreciated that a low profile for spacers 23 as in the present invention is more important when electrodes 14 and 16 are minimally spaced and no contact is to be formed to the source/drain region therebetween.

Although the present invention can be used with larger-geometry graded-channel devices, it is particularly advantageous for devices having gate electrodes 14 and 16 separated by a distance, as measured from the inner sidewall 30 of the first device to the closest inner sidewall 30 of the second device, of about 0.8 microns or less. Also, the extent to which doped regions 36 extend under electrodes 14 and 16 depends upon many factors, as recognized by one of skill in the art, including implant angle, energy, and dose as well as thermal drive time and temperature. As one specific example of typical device geometries for a sub-micron device, for a gate electrode length of about 0.6 microns, doped regions 36 extend about 0.15-0.30 microns from sidewalls 30 into the channel region on the source side. One of skill in the art will recognize, however, that many other variations in geometry are possible, which still fall within the scope of embodiments of the present invention.

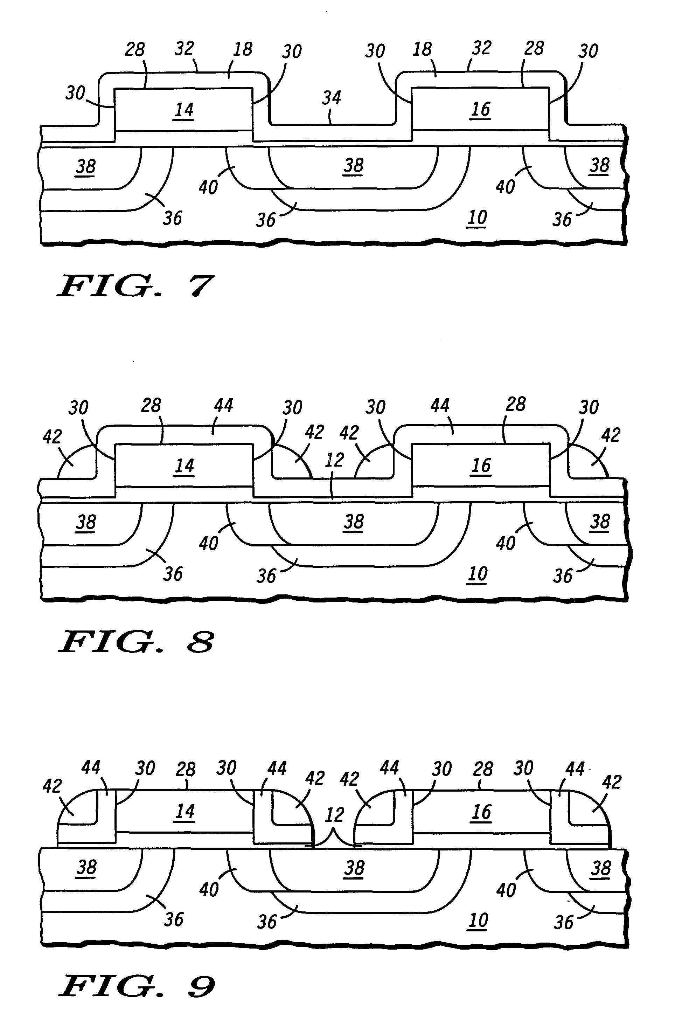

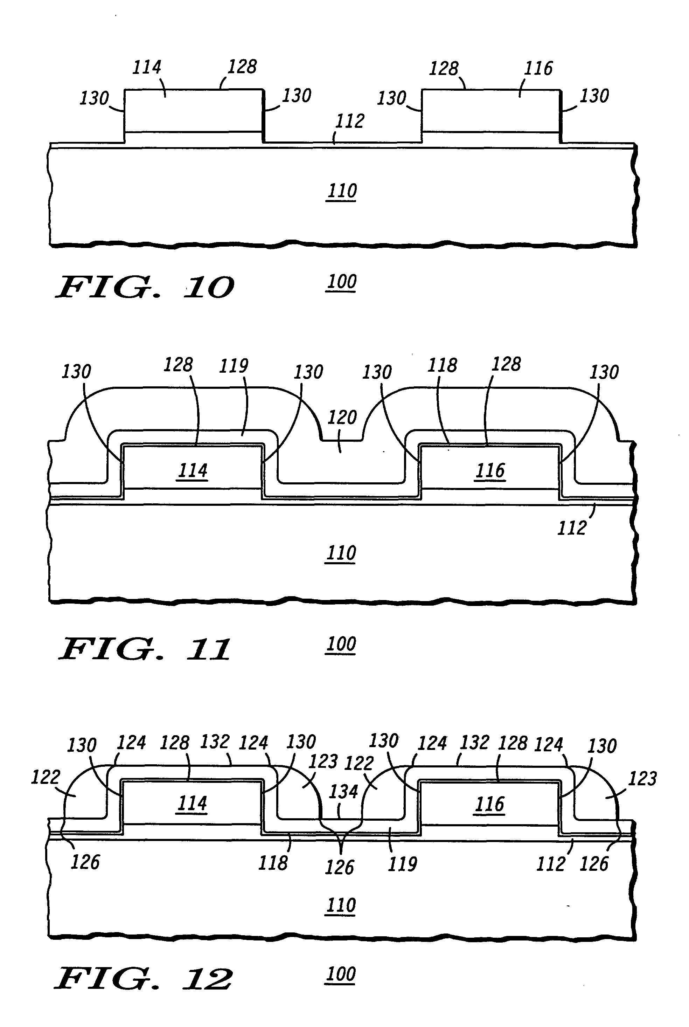

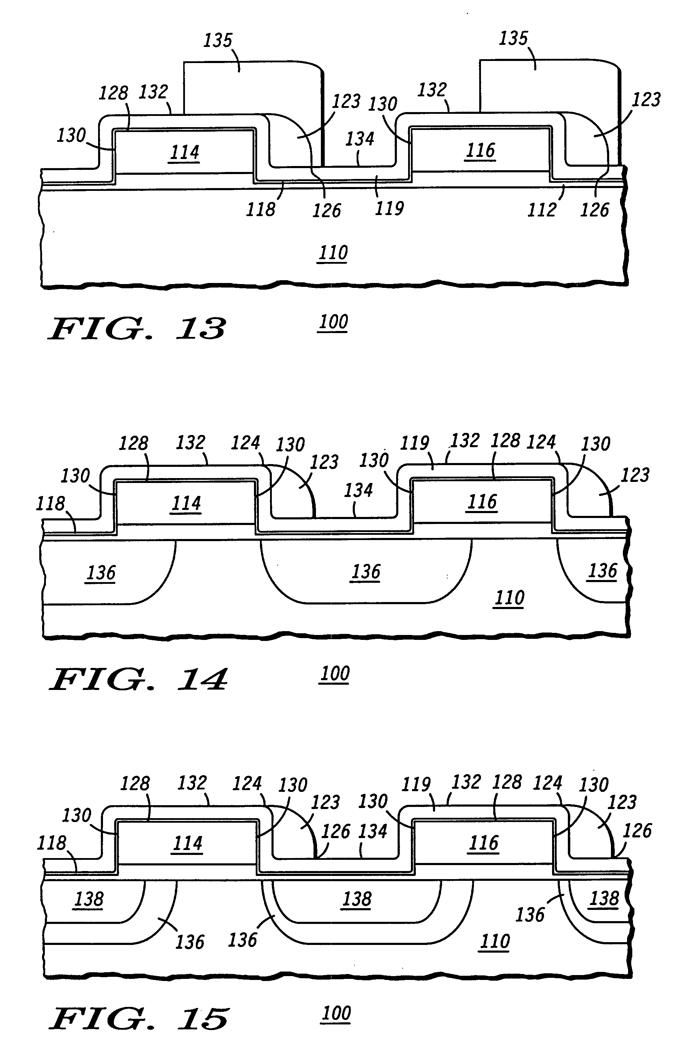

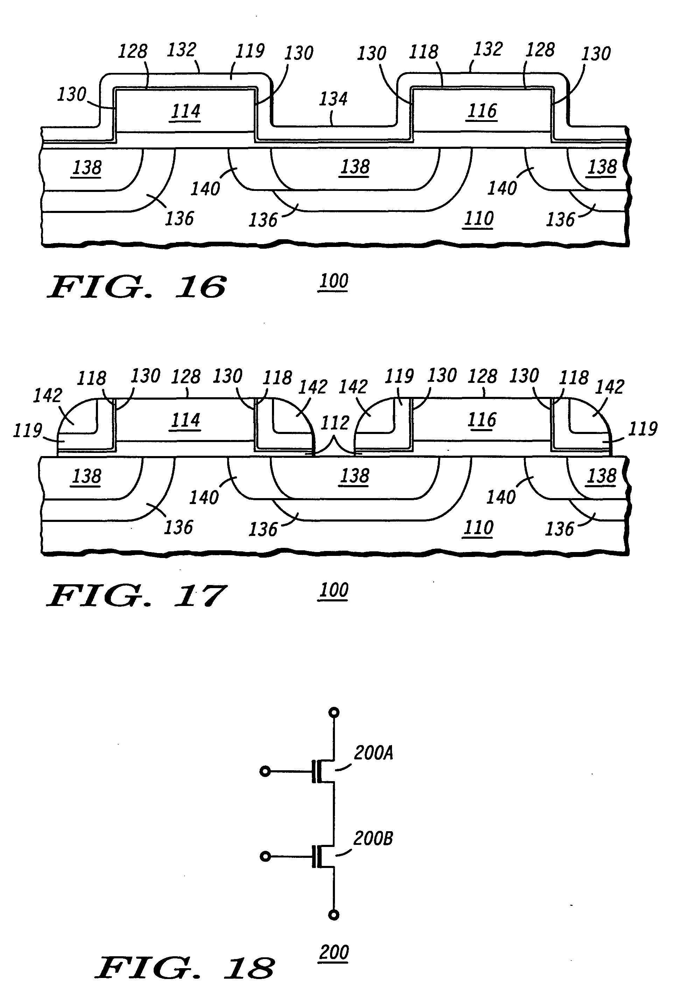

Another advantage of embodiments of the present invention is that spacers 23 are used both for blocking graded-channel dopant from the channel region on the drain side of the device and for later forming LDD extension regions 40 (see FIG. 7). Thus, an extra mask step is avoided by this common usage.

Further details regarding the manufacture of graded-channel field effect transistors are described in both Ma et al., U.S. Patent No. 5,371,394, entitled Double Implanted Laterally Diffused MOS Device and Method Thereof, issued December 6, 1994, and Kaneshiro et al., U.S. Patent No. 5,427,964, entitled Insulated Gate Field Effect Transistor and Method for Fabricating, issued June 27, 1995, which are both hereby incorporated by reference in full.

In FIG. 6, source/drain doped regions 38 are formed, preferably using a common single ion implantation step. In preparation for the formation of source/drain doped regions 38, a previously-formed photoresist mask (not shown) has been patterned to expose only the N-channel devices of the circuit being manufactured. Doping of other devices of the circuit, such as P-channel devices, is blocked during this implant.

Although it is preferred that doped regions 38 be formed in a single implantation step, the source and drain regions can be formed separately, which variation still falls within the scope of the present invention. On the source side of gate electrodes 14 and 16, doped regions 38 are formed substantially aligned with sidewall 30. This doping is done through dielectric layer 18, which has a thickness sufficiently small so that this alignment is substantially not affected. On the drain side of each device, doped regions 38 are substantially aligned to bottom corners 26 of spacers 23. Spacers 23 are retained for an optional lightly-doped drain extension region to be formed later in the process. However, such an extension region is not necessary, and spacers 23 can be removed prior to the formation of doped regions 38 so that the drain regions thereof are substantially aligned to sidewalls 30 on the drain side of each device. By way of example, doped regions 38 can be formed using an arsenic implant of 3x10¹⁵ atoms/cm² at 90 keV, followed by an activation anneal, such as, for example, a rapid thermal anneal (RTA) of about 30 seconds at 1,025°C.

It should also be appreciated that gate electrodes 14 and 16 are preferably doped using the same ion implantation used to form doped regions 38. This simultaneous doping of gate electrodes 14 and 16 is an advantage of the present invention due to the use of spacers 23 and the exposed top surface 32 of dielectric layer 18.

FIG. 7 illustrates the formation of lightly-doped drain extension regions 40. Spacers 23 (see FIG. 6) are removed, for example, by etching. Preferably, the photoresist mask (not shown) used when forming source/drain doped regions 38 and discussed above is not removed during this etch and further remains in place when doping extension regions 40. Next, extension regions 40 are formed substantially aligned with sidewalls 30 of gate electrodes 14 and 16 on the drain side of each device, preferably using an ion implantation of, for example, phosphorus at 120 keV and a dose of 4x10¹² atoms/cm². As is known, extension region 40 preferably has a dopant concentration less than that of doped regions 38. Extension region 40 is disposed adjoining doped region 38 on the drain side.

As just discussed, extension regions 40 are preferably formed with the same photoresist mask (not shown) used to form source/drain doped regions 38. This photoresist mask restricts implant of LDD dopant to the N-channel device layout of the circuit being manufactured.

It should be noted that, when using this preferred approach, the same dopant used to form extension regions 40 will also be introduced into substrate 10 on the source side of the device. However, as will be recognized by one of skill in the art, source doped regions 38 will diffuse further than the dopant used to form extension regions 40. Source doped region 38 is about 1,000 times more highly doped than extension region 40, and as a result, the dopant in source doped region 38 will diffuse faster. An anneal can, if necessary, be done after forming source/drain doped regions 38 and prior to forming extension region 40, but the above photoresist mask must be removed and then re-applied following this anneal. Preferably, a single activation anneal is used to activate doped regions 38 and 40. Such an anneal can be, for example, a rapid thermal anneal of about 30 seconds at about 1,025°C.

If dopant in source doped region 38 does not diffuse further than extension dopant introduced on the source side of each device, there will be increased source resistance and increased threshold voltage variation due to the light compensation of the graded-channel implant by the extension dopant.

Next, as illustrated in FIG. 8, dielectric spacers 42 are formed, for example, by depositing a blanket layer (not shown) of tetraethylorthosilicate (TEOS) on dielectric layer 18 to a thickness of about 200 angstroms and then densifying the deposited TEOS layer. This is represented in FIG. 8 as a dielectric layer 44, which is the combination of old dielectric layer 18 and the new TEOS layer. Next, a silicon nitride layer (not shown) of about 2,000 angstroms thickness is deposited on the TEOS layer, and the nitride layer is anisotropically etched back to provide spacers 42 using conventional techniques.

In FIG. 9, the top surfaces of dielectric layer 44 are etched back to substantially expose top surfaces 28 of gate electrodes 14 and 16. Also, preferably in the same etch step, the portions of dielectric layer 44 and insulating layer 12 between spacers 42 are removed to expose the top surfaces of source/drain doped regions 38. Next, conventional silicide layers (not shown) are preferably formed over source/drain doped regions 38 and gate electrodes 14 and 16. Finally, conventional processing is used to provide contacts (not shown) to doped regions 38 and to complete the devices.

By now it should be appreciated that there has been provided a novel method of forming graded-channel field effect transistors that uses a masking technique having a low aspect ratio, which permits more steeply angled ion implantations and that allows doping of the gate electrode in the same step as the source/drain regions. In addition, this method is especially advantageous for minimally-spaced devices because diffusion of graded-channel dopant into the channel region on the drain side of the device is substantially reduced. Further, the use of spacers 23 as described above avoids the problem of source-limited diffusion. This is in contrast to the use of a photoresist mask in which a mask misalignment may expose too little of the substrate surface on the source side of the device. A further advantage is that the source region to graded-channel region capacitance is more stable due to the significantly lower misalignment tolerance associated with the use of spacers 23 in contrast to that with a photoresist mask.

The foregoing discussion discloses and describes merely exemplary methods and embodiments of the present invention.

## Claims

1. A method of forming a semiconductor device, comprising the sequential steps of:
providing a semiconductor substrate (10) of a first conductivity type and a gate electrode (14) overlying said substrate (10), wherein said gate electrode (14) has a first sidewall, a second sidewall, and a top surface (28);
forming a spacer (23) adjacent to said second sidewall of said gate electrode (14) wherein said spacer (23) has a corner (26) distal from said gate electrode (14);
after said step of forming said spacer (23), forming a first doped region (36) of said first conductivity type in said semiconductor substrate (10) aligned to said first sidewall of said gate electrode (14);
forming a doped source region (38) of a second conductivity type in said semiconductor substrate (10) aligned to said first sidewall of said gate electrode (14);
forming a doped drain region (38) of said second conductivity type in said semiconductor substrate (10) aligned to said corner (26) of said spacer (22);
removing said spacer (23); and
forming a doped drain extension region (40) in said semiconductor substrate (10) aligned to said second sidewall of said gate electrode (14).

2. The method of claim 1 wherein said steps of forming said doped source region and forming said doped drain region are performed using a single, common ion implantation step.

3. The method of claims 1 and 2 further comprising the step of doping said gate electrode (14) through said top surface (28) during said step of forming said doped source region.

4. The method of claims 1, 2, and 3 further comprising the step of annealing said first doped region to provide a graded channel region under said gate electrode (14).

5. The method of claim 1 further comprising:
forming an insulating layer (12) on said semiconductor substrate (10) prior to forming said gate electrode;
forming said gate electrode (14) on said insulating layer (12);
forming a dielectric layer (18) on said insulating layer (12) and said gate electrode (14);
forming a polysilicon layer (20) on said dielectric layer (18); and
anisotropically etching said polysilicon layer (20), using said dielectric layer (18) as an etch stop, to provide said spacer (23).

6. The method of claim 5 wherein said step of anisotropically etching further provides a top corner (24) of said spacer (23) proximate to said gate electrode (14) and level with said dielectric layer (18).

7. The method of claims 1, 2, 3, 4, 5, and 6 wherein said step of forming said first doped region is performed using an angled ion implantation.

## Patentansprüche

1. Ein Verfahren zur Bildung eines Halbleiterbauelements, das die folgenden sequenziellen Schritte aufweist:
Bereitstellung eines Halbleitersubstrats (10) mit einem ersten Typ an Leitfähigkeit und einer Gate-Elektrode (14), die das Substrat (10) überlagert, wobei die Gate-Elektrode (14) eine erste Seitenwand, eine zweite Seitenwand, und eine obere Oberfläche (28) hat;
Bildung eines an die zweite Seitenwand der Gate-Elektrode (14) angrenzenden Abstandstücks (23), wobei das Abstandstück (23) eine Ecke (26) hat, die von der Gate-Elektrode (14) abgewandt ist;
Bildung eines ersten dotierten Bereichs (36) mit dem ersten Typ an Leitfähigkeit im Halbleitersubstrat (10), ausgerichtet an der ersten Seitenwand der Gate-Elektrode (14), nach dem Schritt der Bildung des Abstandstücks (23);
Bildung eines dotierten Source-Bereichs (38) mit einem zweiten Typ an Leitfähigkeit im Halbleitersubstrat (10), ausgerichtet an der ersten Seitenwand der Gate-Elektrode (14) ;
Bildung eines dotierten Drain-Bereichs (38) mit dem zweiten Typ an Leitfähigkeit im Halbleitersubstrat (10), ausgerichtet an der Ecke (26) des Abstandstücks (22) ;
Entfernung des Abstandstücks (23); und
Bildung eines dotierten Drain-Erweiterungsbereichs (40) im Halbleitersubstrat (10), ausgerichtet an der zweiten Seitenwand der Gate-Elektrode (14).

2. Das Verfahren nach Anspruch 1, bei dem die Schritte zur Bildung des dotierten Source-Bereichs und zur Bildung des dotierten Drain-Bereichs unter Verwendung eines einzigen, gemeinsamen Schritts zur Ionenimplantation ausgeführt werden.

3. Das Verfahren nach den Ansprüchen 1 und 2, das weiter den Schritt zur Dotierung der Gate-Elektrode (14) durch die obere Oberfläche (28) während des Schritts zur Bildung des dotierten Source-Bereichs aufweist.

4. Das Verfahren nach den Ansprüchen 1, 2 und 3, das weiter den Schritt zur Ausheilung des ersten dotierten Bereichs aufweist, um einen gradierten Kanal-Bereich unter der Gate-Elektrode (14) bereitzustellen.

5. Das Verfahren nach Anspruch 1, das weiter aufweist:
Bildung einer isolierenden Schicht (12) auf dem Halbleitersubstrat (10), bevor die Gate-Elektrode gebildet wird;
Bildung der Gate-Elektrode (14) auf der isolierenden Schicht (12);
Bildung einer dielektrischen Schicht (18) auf der isolierenden Schicht (12) und auf der Gate-Elektrode (14);
Bildung einer Schicht (20) aus polykristallinem Silizium auf der dielektrischen Schicht (18); und
anisotropes Ätzen der Schicht (20) aus polykristallinem Silizium unter Verwendung der dielektrischen Schicht (18) als Ätzstop, um das Abstandstück (23) bereitzustellen.

6. Das Verfahren nach Anspruch 5, bei dem der Schritt des anisotropen Ätzens weiter eine obere Ecke (24) des Abstandstücks (23) bereitstellt, in unmittelbarer Nähe zur Gate-Elektrode und in gleicher Höhe mit der dielektrischen Schicht (18).

7. Das Verfahren nach den Ansprüchen 1, 2, 3, 4, 5 und 6, bei dem der Schritt zur Bildung des ersten dotierten Bereichs unter Verwendung einer Ionenimplantation im Winkel durchgeführt wird.

## Revendications

1. Procédé de formation d'un dispositif à semiconducteur, comprenant les opérations successives suivantes :
fournir un substrat semiconducteur (10) d'un premier type de conductivité et une électrode de grille (14) qui s'étend sur ledit substrat (10), où ladite électrode de grille (14) possède une première paroi latérale, une deuxième paroi latérale et une surface supérieure (28) ;
former un élément d'écartement (23) adjacent à ladite deuxième paroi latérale de ladite électrode de grille (14), où ledit élément d'écartement (23) possède un coin (26) qui est distant de ladite électrode de grille (14) ;
après ladite opération de formation dudit élément d'écartement (23), former une première région dopée (36) dudit premier type de conductivité dans ledit substrat semiconducteur (10), qui est alignée sur ladite première paroi latérale de ladite électrode de grille (14) ;
former une région source dopée (38) d'un deuxième type de conductivité dans ledit substrat semiconducteur (10), qui est alignée sur ladite première paroi latérale de ladite électrode de grille (14) ;
former une région drain dopée (38) dudit deuxième type de conductivité dans ledit substrat semiconducteur (10), qui est alignée sur ledit coin (26) dudit élément d'écartement (22) ;
retirer ledit élément d'écartement (23) ; et
former une région (40) de prolongement de drain dopée dans ledit substrat semiconducteur (10), qui est alignée sur ladite deuxième paroi latérale de ladite électrode de grille (14).

2. Procédé selon la revendication 1, où lesdites opérations de formation de ladite région source dopée et de formation de ladite région drain dopée sont effectuées au moyen d'une unique opération d'implantation ionique commune.

3. Procédé selon les revendications 1 et 2, comprenant en outre l'opération consistant à doper ladite électrode de grille (14) au travers de ladite surface supérieure (28) pendant ladite opération de formation de ladite région source dopée.

4. Procédé selon les revendications 1, 2 et 3, comprenant en outre l'opération qui consiste à recuire ladite première région dopée de façon à produire une région de canal à gradation de dopage sous ladite électrode de grille (14).

5. Procédé selon la revendication 1, comprenant en outre les opérations suivantes :
former une couche d'isolation (12) sur ledit substrat semiconducteur (10) avant la formation de ladite électrode de grille ;
former ladite électrode de grille (14) sur ladite couche d'isolation (12) ;
former une couche diélectrique (18) sur ladite couche d'isolation (12) et ladite électrode de grille (14) ;
former une couche de silicium polycristallin (20) sur ladite couche diélectrique (18) ; et
graver de manière anisotrope ladite couche de silicium polycristallin (20), en utilisant ladite couche diélectrique (18) comme moyen d'arrêt de gravure, afin de produire ledit élément d'écartement (23).

6. Procédé selon la revendication 5, où ladite opération de gravure anisotrope produit en outre un coin supérieur (24) dudit élément d'écartement (23), qui est proche de ladite électrode de grille (14) et à niveau avec ladite couche diélectrique (18).

7. Procédé selon les revendications 1, 2, 3, 4, 5 et 6, où ladite opération de formation de ladite première région dopée s'effectue au moyen d'une implantation ionique inclinée suivant un certain angle.
